Europäisches Patentamt

European Patent Office

Office européen des brevets

(11) Publication number: **0 105 378**
**B1**

(12) **EUROPEAN PATENT SPECIFICATION**

(45) Date of publication of patent specification: **02.08.89**

(51) Int. Cl.⁴: **H 03 K 23/66,** H 03 K 21/02, H 03 L 7/18

(21) Application number: **83900971.9**

(22) Date of filing: **28.03.83**

(86) International application number:
**PCT/JP83/00093**

(87) International publication number:
**WO 83/03502 13.10.83 Gazette 83/24**

(54) **UP/DOWN COUNTING ARRANGEMENTS.**

(30) Priority: **01.04.82 JP 54465/82**

(43) Date of publication of application:
**18.04.84 Bulletin 84/16**

(45) Publication of the grant of the patent:
**02.08.89 Bulletin 89/31**

(84) Designated Contracting States:
**DE FR GB NL**

(56) References cited:
DE-A-3 247 082
FR-A-2 448 253
GB-A-2 068 667
JP-A-54 000 807
JP-A-54 109 309
IEEE TRANSACTIONS ON CONSUMER
ELECTRONICS, vol. CE-26, no. 3, August 1980,
pages 289-296, IEEE, New York, US; T.
YAMADA et al.: "A high speed NMOS PLL-
synthesizer LSI with on-chip prescaler for
AM/FM receivers"

(73) Proprietor: **SONY CORPORATION**
**7-35 Kitashinagawa 6-Chome Shinagawa-ku**
**Tokyo 141 (JP)**

(72) Inventor: **YAMADA, Takaaki**
**Sony Corporation 7-35, Kitashinagawa**
**6-chome Shinagawa-ku Tokyo 141 (JP)**

(74) Representative: **Cotter, Ivan John et al**
**D. YOUNG & CO. 10 Staple Inn**
**London WC1V 7RD (GB)**

(56) References cited:
ELECTRONIC COMPONENTS &
APPLICATIONS, vol. 1, no. 4, August 1979,
pages 239-248, Eindhoven, NL; U. SCHILLHOF:
"Part 3 - Introduction to microcomputer-
controlled radio tuning system"
IEEE TRANSACTIONS ON CONSUMER
ELECTRONICS, vol. CE-26, no. 3, August 1980,
pages 282-286, IEEE, New York, US; K.
ICHINOSE et al.: "One chip AM/FM digital
tuning system"

Courier Press, Leamington Spa, England.

(56) References cited:
**IEEE TRANSACTIONS ON CONSUMER
ELECTRONICS, vol. CE-24, no. 4, November
1978, pages 507-513, New York, US; T.B.
MILLS: "An AM-FM digital tuning system"**

## Description

This invention relates up/down counting arrangements.

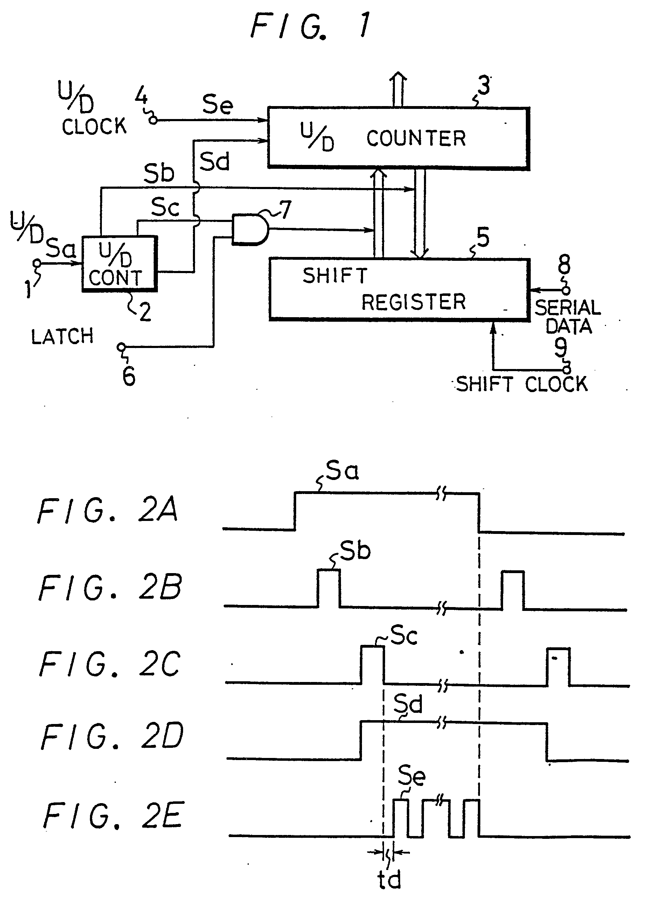

It has been proposed to use an up/down counting arrangement to vary the frequency dividing ratio of a programmable divider used in a phase locked loop. The proposed arrangement is shown in Figure 1 of the accompanying drawings. The arrangement comprises an input terminal 1 to which an up/down counter control signal Sa is supplied, an up/down counter controller 2, an up/down counter 3, an input terminal 4 to which an up/down clock signal is supplied, a shift register 5, an input terminal 6 to which a latch signal is supplied, an AND gate or circuit 7, an input terminal 8 to which a serial data signal is supplied, and an input terminal 9 to which a shift clock signal is supplied.

In a normal mode, the serial data from the input terminal 8 is inputted to the shift register 5 in synchronism with the shift clock signal supplied to the input terminal 9. The serial data is also latched in the up/down counter 3 in response to the latch signal supplied to the input terminal 6. In an up/down mode, when the up/down signal Sa (Figure 2A) supplied to the input terminal 1 is changed from "0" to "1", the content of the counter 3 is transferred to the shift register 5 in response to a signal Sb (Figure 2B) from the controller 2. Then, at the same time when the counter 3 is set into an up mode in response to a signal Sd (Figure 2D) supplied from the controller 2, the AND gate 7 is opened in response to a signal Sc (Figure 2C) supplied from the controller 2 so that, in response to the output from the AND gate 7, the content of the shift register 5 is returned to the counter 3. After that, an up/down clock signal Se (Figure 2e) is supplied from the input terminal 4 to the counter 3 whereby the content thereof is changed in the UP direction.

In order to transfer the serial data from a control circuit (not shown), such as a microprocessor or the like, to the shift register 5, it is necessary to transfer the serial data signal, the shift clock signal and the latch signal. Furthermore, since the signals for controlling the counter 3, the up/down clock signal and the up/down control signal must be transferred, a large number of control lines is required.

UK Patent Application Publication No. GB—A—2 068 667 discloses an up/down counting arrangement which is similar to that described above.

The present invention provides an up/down counting arrangement as set forth in claim 1.

As described in more detail hereinbelow, such an arrangement enables the number of control lines to be reduced.

The invention will now be further described, by way of illustrative and non-limiting example, with reference to the accompanying drawings, in which:

Figure 1 is a block diagram of a previously proposed up/down counting arrangement;

Figures 2A to 2E are diagrams useful for explaining the operation of the arrangement of Figure 1;

Figure 3 is a block diagram of an up/down counting arrangement embodying the present invention;

Figures 4, 5, 6A to 6C and 7A to 7C are diagrams useful for explaining the operation of the arrangement of Figure 3;

Figure 8 is a circuit diagram of an example of a timing controller of the arrangement of Figure 3;

Figure 9 is a circuit diagram of an example of a flip-flop circuit of the timing controller of Figure 8;

Figures 10A to 10N are diagrams useful for explaining the operation of the timing controller of Figure 8;

Figure 11 is a circuit diagram of another part of the arrangement of Figure 3;

Figure 12 is a diagram used to explain the operation of the arrangement embodying the invention; and

Figure 13 is a circuit diagram of a further part of the arrangement of Figure 3.

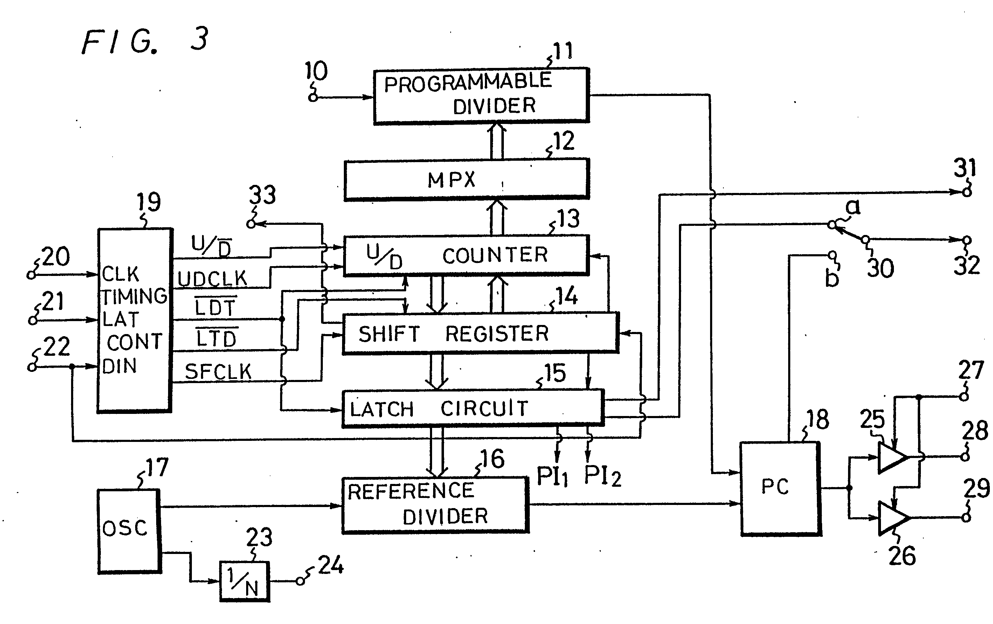

An embodiment of the invention will now be described with reference to Figures 3 to 13 for a case in which the invention is applied, by way of example, to a phase locked loop (PLL) used in a channel selection section of a synthesiser receiver.

Figure 3 shows the overall arrangement of the embodiment. A frequency-divided output obtained by frequency-dividing an output from a voltage controlled oscillator in the PLL circuit by a pre-scaler is supplied via an input terminal 10 to a programmable frequency divider 11 formed by an 18-bit counter in the case of, for example, a frequency moduled (FM)/television (TV) input and a 16-bit counter in the case of an amplitude modulated (AM) input. The arrangement shown in Figure 3 includes a multiplexer 12, an 18-bit up/down counter 13, a 20-bit shift register 14, a 19-bit latch circuit 15, 14-bit reference frequency divider 15, a reference oscillator 17 which takes 4.5 MHz as, for example, a standard and is capable of covering 100 kHz to 10 MHz, a phase comparator 18 for comparing the phases of the output signals from the frequency dividers 11 and 16 with each other, and a timing controller 19 which generates various timing signals. The timing controller 19 includes a CLK terminal (20-bit serial data input clock input terminal serving also as a data up/down clock input terminal), an LAT terminal (shift register input data latch signal input terminal serving also as an up/down mode selecting terminal) and a DIN terminal (data input terminal serving also as an up/dow terminal). These terminals are supplied with corresponding control signals through control signal input terminals 20, 21 and 22 from a microcomputer (not shown).

A 1/N frequency divider 23 (of which the value of N is selected, for example, to be 12) generates a system clock signal at an output terminal 24. Tristate buffers 25 and 26 operate such that, when a control signal to be applied to a control signal input terminal 27 is "1", they are in a normal operation mode and deliver the output from the phase comparator 18 to two independent and equivalent output terminals 28 and 29, while, when the above control signal is "0", they function to make the output terminals 28 and 29 forcibly of high impedance. Thus, various applications such as combination with an analog automatic frequency control (AFC) circuit, an intermittent tuning circuit and so on become possible. The values of the bit processing in the various above circuits can arbitrarily be changed in accordance with the bit number of the data to be processed.

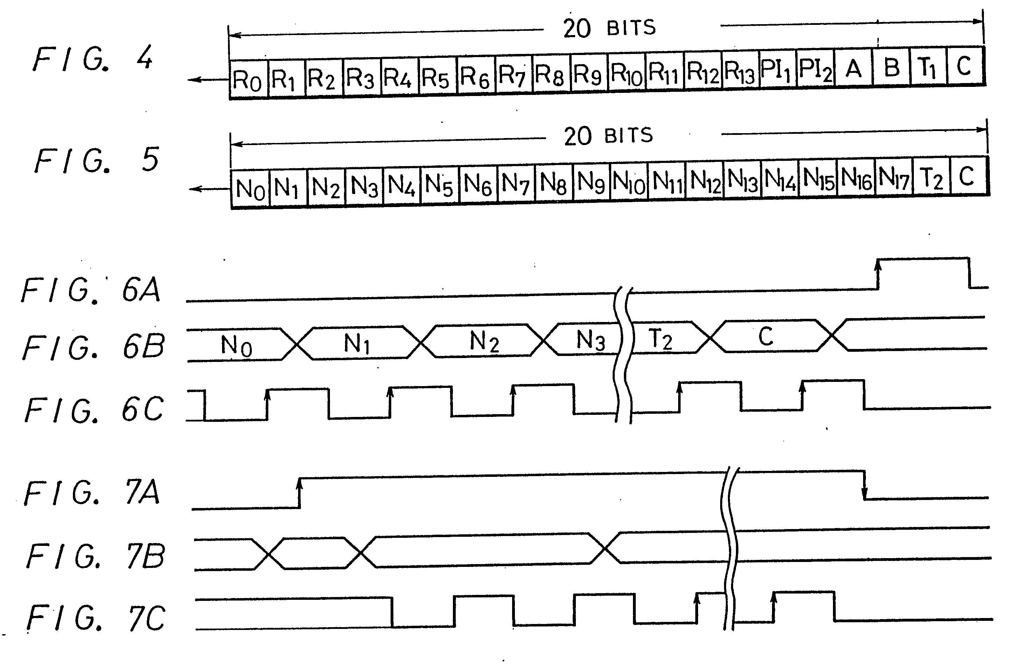

The above embodiment employs 20-bit binary codes shown in Figures 4 and 5. Figure 4 shows control input data to the reference frequency divider 16 and the like. This data is a kind of initial state setting data which must be inputted without fail when power is applied or upon band switching, etc.

In Figure 4, $R_0$ to $F_{13}$ represent binary values with $R_0$ taken as the least significant bit (LSB). The value of the frequency division which is supplied to the reference frequency divider 16 is represented by the above 14 bits. $PI_1$ and $PI_2$ are used to specify the signal input terminal. The programmable frequency divider 11 is provided at its input side with three independent AM, FM and TV input terminals (not shown). These terminals are specified by the combination of the 2 bits $PI_1$ and $PI_2$. For example, when $PI_1$ and $PI_2$ are (1, 0) the AM signal input terminal is specified, when they are (0, 1) the FM signal input terminal is specified, and when they are (1, 1) the TV signal input terminal is specified. A and B designate bits for controlling the pre-scaler and outputting an unlocked signal. When $T_1$ is "0", a movable contact of a switch 30 is connected to a contact $a$ thereof to allow values A and B to be delivered directly to terminals 31 and 32, respectively. These signals can be utilised for various purposes such as switching the frequency-dividing ratio of the pre-scaler in the PLL circuit, switching the constant of a low-pass filter (not shown), a band switching signal and so on. The frequency-dividing ratio of the pre-scaler is switched by the combination of the 2 bits A and B. For example, when A and B are (0, 1) it is switched to 1/1, when they are (1, 0) it is switched to 1/2, when they are (0, 1) it is switched to 1/4, and when they are (1, 1) it is switched to 1/8. Moreover, when $T_1$ is "1", the switch 30 is changed over so that its movable contact is connected to a contact $b$ thereof to permit a signal indicative of a locked/unlocked state of the phase comparator 18 to be delivered to the terminal 32. When the signal at the terminal 32 is, for example, "1", the unlocked state is indicated, while when it is "0" the locked state is indicated. Accordingly, this signal can be used as a muting signal. On the other hand, when $T_1$ is "0", the data A and B appears at the terminal 31. C designates a code which determines the latch direction of the input data. When C is, for example, "0", the input data is latched in the reference frequency divider 16, while when it is "1" the input data is latched in the programmable frequency divider 11. When the control input data of the reference frequency divider 16 is handled, it is "0".

Figure 5 shows data which determines the frequency dividing ratio of the programmable frequency divider 11. $N_0$ to $N_{17}$ are binary values with $N_0$ taken as the LSB. The above 18 bits are used to represent the value of the frequency dividing number (divisor) which is supplied to the programmable frequency divider 11. The frequency-dividing number is made different depending on the signal input terminal selected by the combination of $PI_1$ and $PI_2$ above. When, for example, the AM, FM and TV signal input terminals are selected, the ranges of the frequency-dividing number are from 4 to 65,537, 16 to 262,151 and 32 to 524,302, respectively. $T_2$ is used to select a test mode and is always "0" in a normal operational state in which testing is not carried out. C designates a code which determines the latch direction of the input data similarly as above. In this case, it is made equal to "1".

A method of inputting the control signal will now be described. In the present embodiment, there are two modes, namely a data latch mode (ordinary mode) and an up/down mode, which are little different from each other in the signal input method.

The data latch mode is selected when the LAT terminal of the timing controller 19 is set in the "0" state, as shown in Figure 6A, by a command from the microcomputer. Then, the data, as shown in Figure 6B, which is supplied to the DIN terminal of the timing controller 19 from the microcomputer, is latched bit by bit into the 20-bit shift register 14 at the leading edges of the pulses of a clock (Figure 6C) which is applied to the CLK terminal of the timing controller 19 from the microcomputer. After the data has been sent to the shift register 14, if the LAT terminal of the controller 19 is set to the "1" state the data is latched. At that time, depending on the state of the final bit of the data, namely, the state of C in Figures 4 and 5, the input data is latched in either the programmable frequency divider 11 or the reference frequency divider 16. Namely, if C is "1", this represents input data for the divider 11 so that the data thus latched is taken into the divider 11, while if C is "0" this represents control input data for the divider 16 and so on so that the data thus latched is taken into the divider 16.

In practical use, when, in response to the command from the microcomputer, the 20-bit signal shown in Figure 4, which is the control input data for the reference frequency divider 16 and the like, is first generated from the controller 19 and then latched, and then the 20-bit signal shown in Figure 5, which is the data for setting the programmable frequency divider 11, is delivered, the whole internal state is set. That is, in the initial setting of the state, it is necessary to input a total of 40 bits in two steps. However, when the receiving frequency is changed within the same band, it is sufficient to change only 20 bits of data.

When the LAT terminal of the controller 19 is set to the "1" state, as shown in Figure 7A, the up/down counter mode is selected. In this mode, the frequency dividing number of the programmable frequency divider 11 can be increased or decreased by the use of a data latch terminal 33. In other words, when the LAT terminal of the controller 19 becomes "1", the data is latched from the shift register 14 and, at the same time, the mode is changed to the up/down mode so that in response to "1" and "0" states of the data, which is shown in Figure 7B and supplied to the DIN terminal of the controller 19 from the microcomputer, the content of the up/down counter 13 is increased or decreased one by one at the leading edges of pulses of a clock signal (Figure 7C) at the CLK terminal of the controller 19.

When the LAT terminal of the controller 19 becomes "0", the mode is returned to the normal mode and, at the same time, the content of the up/down counter 13 is, on the contrary, loaded into the shift register 14. The thus loaded content of the shift register 14 can be derived from the terminal 33 by inputting the clock signal to the CLK terminal of the controller 19, from which the present frequency dividing number of the programmable frequency divider 11 can be known. The content of the shift register 14 is delivered from the terminal 33 successively so that, if the successive output is returned to the controller 19, it is possible to confirm the transmitted data from the controller 19.

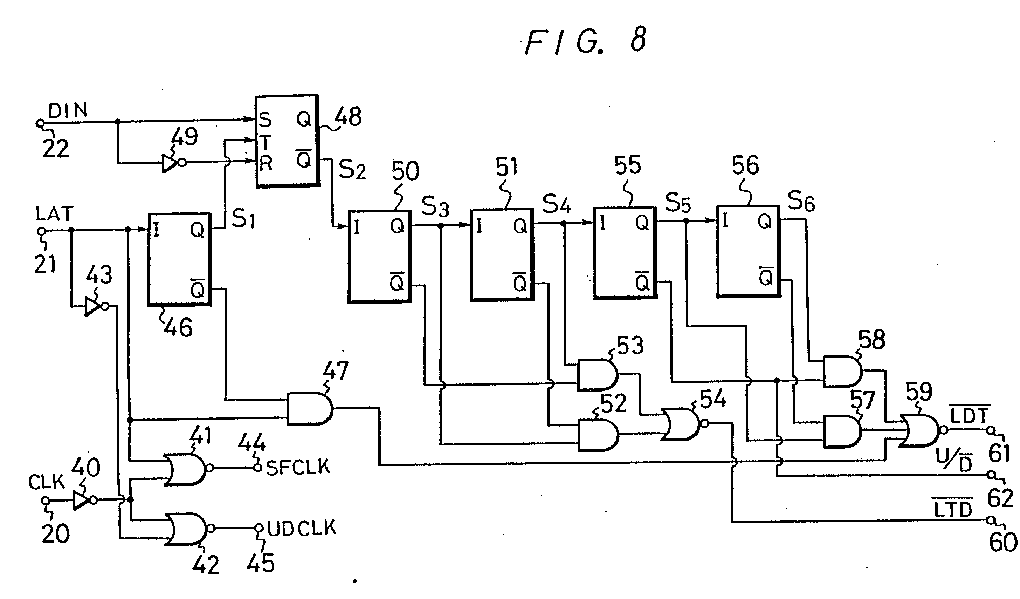

Figure 8 shows an example of a circuit for the timing controller 19. The control signal input terminal 20 is connected through an inverter 40 to one input terminal of each of two NOR gates or circuits 41 and 42, while the control signal input terminal 21 is connected to another input terminal of the NOR gate 41 and also connected through an inverter 43 to another input terminal of the NOR gate 42. Output terminals of the NOR gates 41 and 42 are led out to output terminals 44 and 45 which are connected to the shift register 14 and the up/down counter 13 (both of which are shown in Figure 3), respectively. The control signal input terminal 21 is connected to a delay circuit, for example an input terminal I of a flip-flop circuit 46, and also to one input terminal of an AND gate or circuit 47. An output terminal Q of the flip-flop circuit 46 is connected to a trigger terminal T of a flip-flop circuit 48, while an inverting output terminal $\overline{Q}$ thereof is connected to another input terminal of the AND gate 47.

The control signal input terminal 22 is connected to a set terminal S of the flip-flop circuit 48 and also is connected through an inverter 49 to a reset terminal R of the flip-flop circuit 48. An inverting output terminal $\overline{Q}$ of the flip-flop circuit 48 is connected to a delay circuit, for example an input terminal I of a flip-flop circuit 50, while an output terminal Q of the flip-flop circuit 50 is connected to a delay circuit, for example an input terminal I of a flip-flop circuit 51. The output terminal Q of the flip-flop circuit 50 and an inverting output terminal $\overline{Q}$ of the flip-flop circuit 51 are connected to respective input terminals of an AND gate or circuit 52, while an inverting output terminal $\overline{Q}$ of the flip-flop circuit 50 and an output terminal Q of the flip-flop circuit 51 are connected to respective input terminals of an AND gate or circuit 53. Output terminals of the AND gate 52 and 53 are connected to respective input terminals of a NOR gate or circuit 54.

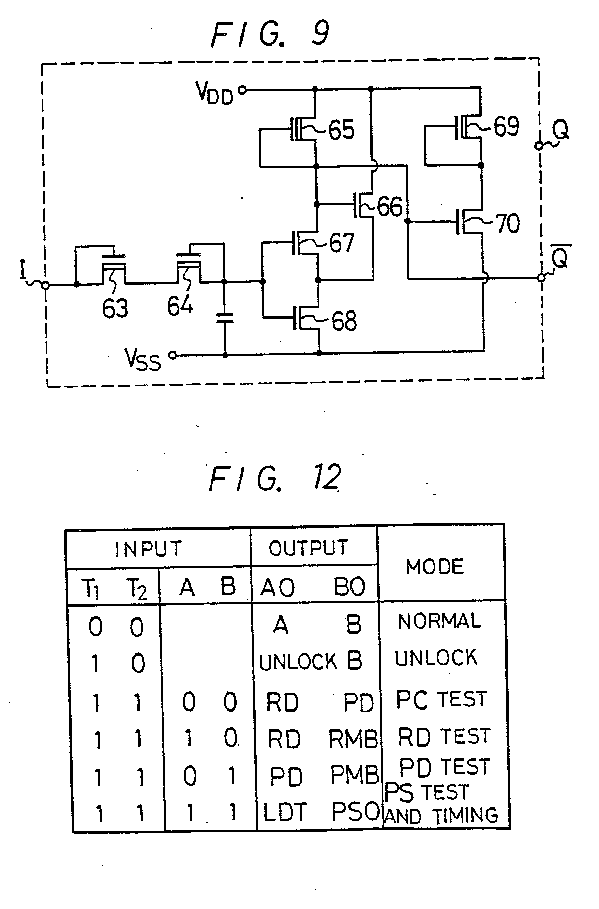

The output terminal Q of the flip-flop circuit 51 is connected to a delay circuit, for example an input terminal I of a flip-flop circuit 55, while an output terminal Q of the flip-flop circuit 55 is connected to a delay circuit, for exampple an input terminal I of a flip-flop circuit 56. The output terminal Q of the flip-flop circuit 55 and an inverting output terminal $\overline{Q}$ of the flip-flop circuit 56 are connected to respective input terminals of an AND gate or circuit 57, while the inverting output terminal $\overline{Q}$ of the flip-flop circuit 55 and an output terminal Q of the flip-flop circuit 56 are connected to respective input terminals of an AND gate or circuit 58. Output terminals of the AND gates 57 and 58 and an output terminal of the AND gate 47 are connected to respective input terminals of a NOR gate or circuit 59. An output terminal of the NOR gate 54 is led out to an output terminal 60 which is connected to the shift register 14 (Figure 3), while an output terminal of the NOR gate 59 is led out to an output terminal 61 which is connected to the up/down counter 13 and the latch circuit 15 (both shown in Figure 3). Moreover, the inverting output terminal $\overline{Q}$ of the flip-flop circuit 55 is led out to an output terminal 62 which is connected to the up/down counter 13. Each of the flip-flop circuits 46, 50, 51, 55 and 56 used as a delay circuit may, as shown for example in Figure 9, consist of field effect transistors (FETs) 63 and 64 forming a delay section, FETs 65 to 68 forming a hysteresis section and FETs 69 and 70 forming a buffer section.

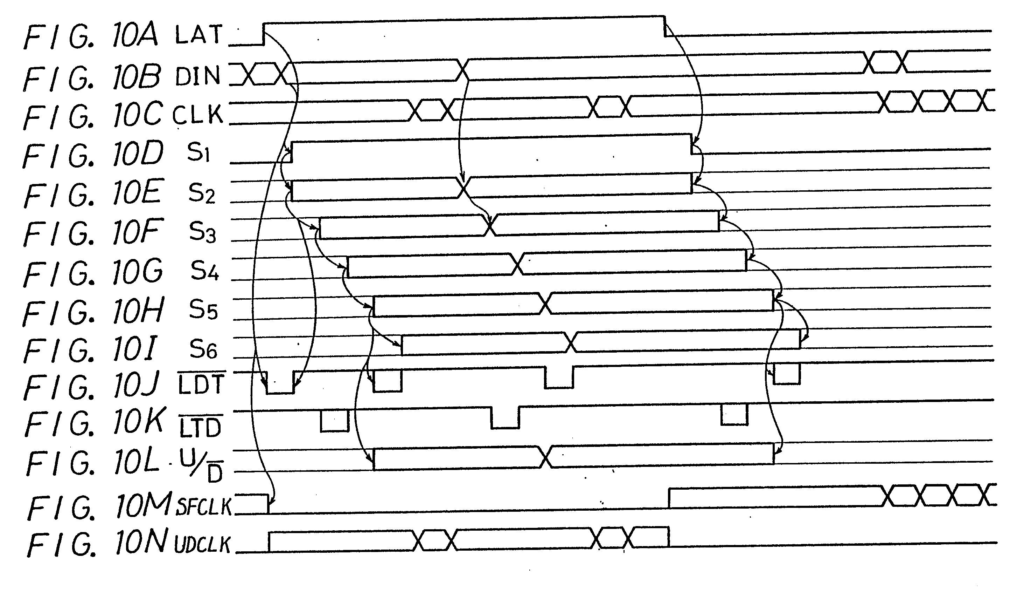

The operation of the circuit shown in Figure 8 will now be described with reference to Figure 10.

When a signal LAT (Figure 10A), which is supplied to the control signal input terminal 21, changes from "0" to "1", the circuit operation changes from the ordinary mode (data latch mode) to the up/down mode. When the signal LAT changes from "0" to "1", the AND gate 47 and the NOR gate 59 are both opened to allow a load signal $\overline{LDT}$ (Figure 10J) to be delivered to the output terminal 61 whereby the content of the shift resistor 14 (Figure 3) is latched in the up/down counter 13 (Figure 3). Also, in the ordinary mode, a shift clock signal SFCLK for the shift register 14, which is supplied through the NOR gate 41 to the output terminal 44 in response to a clock signal CLK (Figure 10C), which is supplied from the control signal input terminal 20, is interrupted as shown in Figure 10M since the NOR gate 41 is closed by the change of the signal LAT from "0" to "1". On the other hand, an up/down clock signal UDCLK (Figure 10N) for the up/down counter 13, which is not yet delivered in the ordinary mode, is delivered to the output terminal 45 since the NOR gate 42 is opened by the change of the signal LAT from "0" to "1".

In synchronism with the change of the signal LAT from "0" to "1", an output signal $S_1$ (Figure 10D) is generated at the output terminal Q of the flip-flop circuit 46 after a predetermined delay time and is supplied to the trigger terminal T of the flip-flop circuit 48. The flip-flop circuit 48 delivers its input signal as it is when the level of the trigger terminal T is, for example, "1", while when it is "0" the flip-flop circuit holds the preceding state. Accordingly, when the level of the trigger terminal T is changed from "0" to "1" by application of the signal $S_1$ thereto, a signal DIN (Figure 10B), which is supplied to the control signal input terminal 22, is directly delivered to the inverting output terminal $\overline{Q}$ of the flip-flop circuit 48 as an output signal $S_2$ as shown in Figure 10E. The signal $S_2$ is sequentially transmitted with a predetermined delay time to the flip-flop circuits 50, 51, 55 and 56 at the later stages so that output signals $S_3$, $S_4$, $S_5$ and $S_6$ as shown in Figures 10F to 10I appear at the output terminals Q of the respective flip-flop circuits 50, 51, 55 and 56. During only the period in which the levels of the signals $S_3$ and $S_4$ are different from each other, the NOR gate 54 is opened by way of the AND gates 52 and 53 to permit a load signal $\overline{\text{LTD}}$ as shown in Figure 10K to be delivered to the output terminal 60 whereby the content of the up/down counter 13 is temporarily transferred to the shift register 14. When the signal $S_5$ changes from "0" to "1", an up/down signal $U/\overline{D}$ as shown in Figure 10L appears at the output terminal and a next load signal $\overline{\text{LDT}}$ as shown in figure 10J appears at the output terminal 61 whereby the content temporarily stored in the shift register 14 is returned to the up/down counter 13. The reason why, before the generation of the up/down signal $U/\overline{D}$, the content of the up/down counter 13 is temporarily held in the shift register 14 and returned to the up/down counter 13 at the same time that the signal $U/\overline{D}$ is generated, is due to the manner of construction of the up/down counter: when the up/down counter is of regular construction, if data is latched in the up/down counter before switching of the up/down modes, the up/down counter is destroyed upon switching the up/down modes.

The content of the up/down counter 13, in the up/down mode, is decreased or increased one by one in response to the level of the signal DIN, which is indicative of the up mode and down mode and supplied to the input terminal 22, at the leading edges of the pulses of the up/down clock signal UDCLK (Figure 10N) at the output terminal 45. By way of example, when the level of the signal DIN is "1", the content of the up/down counter 13 is increased one by one at each leading edge of the clock signal UDCLK supplied thereto, while when the level thereof is "0" it is decreased one by one at the leading edge of the clock signal UDCLK at every time that the latter is applied.

Subsequently, when the signal LAT changes from "1" to "0" as shown in Figure 10A, the circuit operation is changed from the up/down mode to the normal mode, namely the data latch mode. Then, in synchronism with the change of the signal LAT from "1" to "0", the signals $S_1$ to $S_6$ change from "1" to "0" with a predetermined delay time. Then, during the period in which the levels of the signals $S_3$ and $S_4$ are different from each other, the load signal $\overline{\text{LTD}}$ appears at the output terminal 60 whereby the content of the up/down counter 13 is loaded into the shift register 14. The thus loaded content of the shift register 14 can be derived at the output terminal 33 (Figure 3) by inputting to the shift register 14 the shift clock signal SFCLK (Figure 10M), the level of which is changed from "0" to "1" in synchronism with the change of the signal LAT from "1" to "0". In this way, it is possible to know the present frequency dividing number of the programmable frequency divider 11 (Figure 3) substantially.

Further, in synchronism with the change of the signal $S_5$ from "1" to "0", the up/down signal U/D at the output terminal 62 changes from "0" to "1" as shown in Figure 10L so as not to be substantially related to the signal DIN so that, thereafter, the signal U/D holds the level of the signal DIN at the point in time when its level is changed. The same operation is carried out for the signals $S_2$ to $S_6$ and thus these signals, after they are changed from "1" to "0", hold the level of the signal DIN at the point in time when the level thereof was changed.

Furthermore, in synchronism with the change of the signal $S_5$ from "1" to "0", namely at the same time when the generation of the signal $U/\overline{D}$ is stopped, the load signal $\overline{\text{LDT}}$ as shown in Figure 10J appears at the output terminal 61 whereby the content of the shift register 14 is returned to the up/down counter 13.

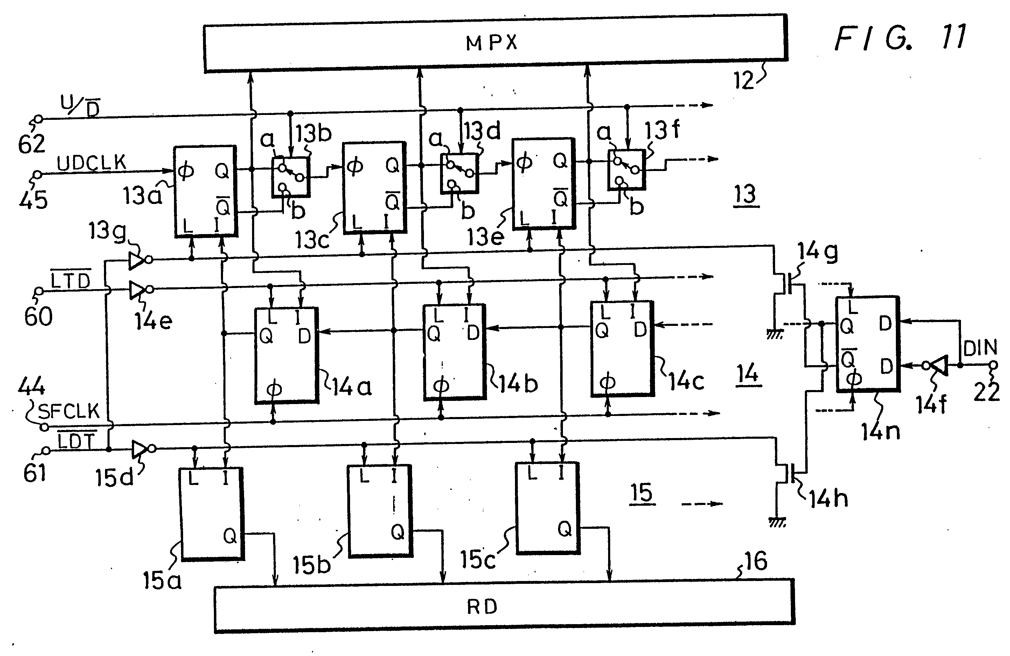

Figure 11 shows an example of practical circuitry for the up/down counter 13, the shift register 14 and the latch circuit 15. The output terminal 45, from which the up/down clock signal UDCLK is delivered, is connected to a clock terminal φ of a flip-flop circuit 13a in the counter 13. An output terminal Q and an inverting output terminal $\overline{Q}$ of the flip-flop circuit 13a are connected through a switching circuit 13b to a clock terminal φ of a flip-flop circuit 13c. An output terminal Q and an inverting output terminal $\overline{Q}$ of the flip-flop circuit 13c are connected through a switching circuit 13d to a clock terminal φ of a flip-flop circuit 13e. An output terminal Q and an inverting output terminal $\overline{Q}$ of the flip-flop circuit 13e are connected through a switching circuit 13f to a clock terminal of a flip-flop circuit (not shown) at a succeeding stage. These flip-flop circuits and switching circuits are provided in numbers corresponding to the bit number of the up/down counter 13, which bit number depends upon its bit processing. The switching circuits 13b, 13d, 13f ... are changed in position in response to the up/down signal U/$\bar{\text{D}}$ from the output terminal 62. For example, in the down mode, the movable contacts of the switching circuits 13b, 13d, 13f ... are connected to contacts a thereof, while in the up mode they are changed in position to be connected to contacts b thereof.

The output terminal 61, from which the load signal $\overline{\text{LDT}}$ is derived, is connected through an inverter 13g to a load terminal L of each of the flip-flop circuits 13a, 13c and 13 ... in the up/down counter 13 so that each of the flip-flop circuits 13a, 13c, 13e ... is set in the load state to receive the input signal when the load terminal L is at a predetermined level, for example "1".

The output terminal 44, from which the shift clock signal SFCLK is derived, is connected to clock terminals φ of flip-flop circuits 14a, 14b, 14c ... 14n connected in cascade in the shift register 14. These flip-flop circuits are provided in a number corresponding to the bit number of the shift register 14, which bit number depends on its bit processing. The output terminal 60, from which the load signal $\overline{\text{LTD}}$ is derived, is connected through an inverter 14e to a load terminal L of each of the flip-flop circuits 14a, 14b, 14c ... 14n. Thus, each of the flip-flop circuits 14a, 14b, 14c ... 14n is set in a load state for serial input data, namely the data from the input terminal 22, when the level of the load terminal L becomes "0", and is set in a load state for parallel input data, namely the data from the up/down counter 13, when the level of the load terminal L becomes "1". Further, the input terminal 22 to which the signal DIN is applied is connected to a data input terminal D of the flip-flop circuit 14n and also connected through an inverter 14f to a data inverting input terminal D thereof.

The flip-flop circuit for the final bit of the data inputted to the shift register 14, namely the flip-flop circuit 14n, is provided at its output side with FETs 14g and 14h arranged in a wired-OR constructions, which check the level of the code C, which determines the latch direction of the input data in Figures 4 and 5, and then selectively supply the content of the shift register 14 to the up/down counter 13 or the latch circuit 15. That is, the gate terminal of the FET 14g is connected to an inverting output terminal $\bar{\text{Q}}$ of the flip flop circuit 14n, the drain terminal thereof is connected to the load terminal L of each of the flip-flop circuits 13a, 13c, 13e ... in the up/down counter 13 and the source terminal thereof is grounded. The gate terminal of the FET 14h is connected to an output terminal Q of the flip-flop circuit 14n, the drain terminal thereof is connected to a load terminal L of each of flip-flop circuits 15a, 15b, 15c ... in the latch circuit 15 and the source terminal therof is grounded. The flip-flop circuits forming the latch circuit 15 are provided in a number corresponding to the bit number of the latch circuit 15, which bit number depends on its bit processing. The output terminal 61, from which the load signal $\overline{\text{LDT}}$ is derived, is connected to the load terminals L of the flip-flop circuits 15a, 15b, 15c ... through an inverter 15d. An output terminal Q of each of the flip-flop circuits 15a, 15b, 15c ... is connected to the reference frequency divider 16.

Output terminals Q of the remaining flip-flop circuits, except for the final bit flip-flop circuit 14n, in the shift register 14, namely the flip-flop circuits 14a, 14b, 14c ... in Figure 11, are respectively connected to input terminals I of the corresponding flip-flop circuits 13a, 13b, 13c ... in the up/down counter 13 and also connected to input terminals I of the corresponding flip-flop circuits 15a, 15b, 15c ... in the latch circuit 15. An output terminal Q of each of the flip-flop circuits 13a, 13c, 13e ... in the up/down counter 13 is connected through the multiplexer 12 to the programmable frequency divider 11 (Figure 3) and also connected to an input terminal I of each of the corresponding flip-flop circuits 14a, 14b, 14c ... in the shift register 14.

In the normal mode (data latch mode), in which the signal LAT is "0", the data signal DIN from the input terminal 22 is supplied bit by bit to the respective flip-flop circuits 14a, 14b, 14c ... 14n in the shift register 14 at the leading edges of the shift clock signal SFCLK from the output terminal 44. When the signal LAT becomes "1", the load signal $\overline{\text{LDT}}$ is generated at the output terminal 61 so that the respective flip-flop circuits of the up/down counter 13 and the latch circuit 15 are all set in the load state. However, depending on the state of the final bit of the input data, the load state of one side of the respective flip-flop circuits in the up/down counter 13 and the latch circuit 15 is restricted, and only the other side thereof is substantially set in the load state. Namely, when the last bit (the C code in Figures 4 and 5) of the data supplied to the input terminal 22 is "1", the FET 14h is turned on and the level of the load terminal of each of the flip-flop circuits 15a, 15b, 15c ... in the latch circuit 15 becomes "0" so that its load state is restricted, while, since the FET 14g is in the off state, only each of the flip-flop circuits 13a, 13c, 13 ... in the up/down counter 13 is set in the load state. Thus, the content of the shift register 14 is latched in the up/down counter 13 and then used as the data for the programmable frequency divider 11. However, when the last bit of the input data supplied to the input terminal 22 is "0", the FET 14g is turned on and the FET 14h is turned off so that the load state of each of the flip-flop circuits 13a, 13c, 13e ... in the up/down counter 13 is restricted. As a result, the content of the shift register 14 is latched in the latch circuit 15 and then used as the data for the reference frequency divider 16.

Then, when the signal LAT becomes "1", the mode is changed to the up/down mode and each of the flip-flop circuits 14a, 14b, 14c, ... 14n in the shift register 14 is set in the load state by the load signal $\overline{\text{LTD}}$ from the output terminal 60 so that the content of the up/down counter 13 is temporarily transferred to the shift register 14. At the same time that the up/down signal U/$\bar{\text{D}}$ is generated at the output terminal 62, the load signal $\overline{\text{LDT}}$ is

generated at the output terminal 61 so that the up/down counter 13 is again set in the load state, returning the content of the shift register 14 to the up/down counter 13. After that, the up/down clock signal UDCLK from the output terminal 45 is received so that, when the signal U/D is "0", the switching circuits 13b, 13d, 13f ... are each changed in position so that their movable contacts are connected to the contacts a and the down mode is selected. Thus, the content of the up/down counter 13 is decreased one by one at the leading edges of the up/down clock signal UDCLK. On the other hand, when the signal U/$\overline{D}$ is "1", the switching circuits 13b, 13d, 13f ... are each changed in position so that their movable contacts are connected to the contacts b so that the up mode is selected, thus increasing one by one the content of the up/down counter 13 at the leading edges of the up/down clock signal UDCLK.

Figure 12 shows in detail an example of a relationship between an output signal AO provided at the output terminal 32 (Figure 2) and an output signal BO provided at the output terminal 31 (Figure 3) by the combination of the bit codes A, B and $T_1$ for the pre-scaler controlling and the unlock signal outputting shown in Figure 4 and the test bit code $T_2$ shown in Figure 5. When ($T_1$, $T_2$) is, for example, (0, 0), the normal mode is indicated under which the values of A and B are respectively delivered to the output terminals 32 and 31 as they are, while when it is (1, 0) the unlocked mode is indicated under which the unlocked state of the phase comparator 18 (Figure 3) is produced at the output terminal 32 and the value of B is produced at the output terminal 31. When ($T_1$, $T_2$) and (A, B) are (1, 1) and (0, 0), the output signal RD of the reference frequency divider 16 (Figure 3) appears at the output terminal 32 and the output signal PD of the programmable frequency divider 16 (Figure 3), appears at the output terminal 31, whereby the test mode of the phase comparator 18 (Figure 3) under which the operation of the phase comparator 18 can be checked is indicated. When (1, 1) and (1, 0) appear, the output signal RD of the reference frequency divider 16 appears at the output terminal 32 and at least the most significant bit RMB of the output signal from the divider 16 appears at the output terminal 31 so that the test mode of the divider 16 under which checking of the operation of the divider 16 becomes possible is indicated. When (1, 1) and (0, 1) appear, the output signal PD of the programmable frequency divider 16 appears at the output terminal 32 and at least the most significant bit PMB of the output signal of the programmable frequency divider 11 appears at the output terminal 31 so that the test mode of the divider 11 under which the operation of the divider 11 can be checked is indicated. When (1, 1) and (1, 1) appear, the pre-scaler test and timing modes are indicated, under which the data load signal LDT appears at the output terminal 32 and the output signal PSD of the pre-scaler (not shown) appears at the output terminal 31.

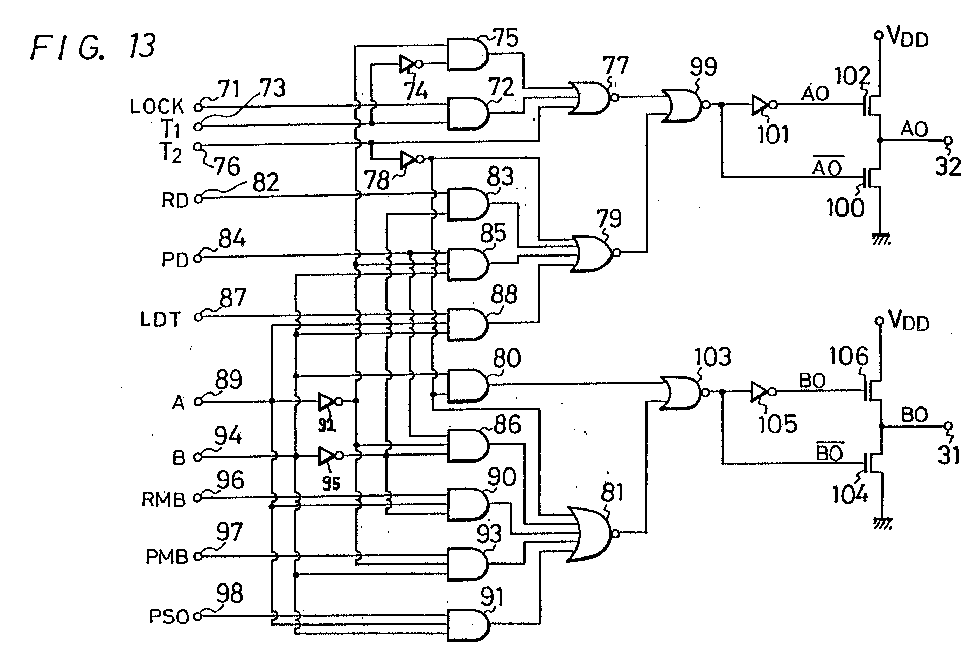

Figure 13 shows an example of practical circuitry which carries out the logical operations describes above with reference to Figure 12. In practice, the output terminals 31 and 32 in Figure 3 are led out through gate circuits as shown in Figure 13. An input terminal 71 (which substantially corresponds to the contact b of the switch 30 in Figure 3), to which the locked signal LOCK is supplied from the phase comparator 18 (Figure 3), is connected to one input terminal of an AND gate or circuit 72, while an input terminal 73 to which the bit $T_1$ is applied from the shift register 14 or the latch circuit 15 (each shown in Figure 3) is connected to another input terminal of the AND gate 72 and also is connected through an inverter 74 to one input terminal of an AND gate or circuit 75. An input terminal 76 to which the bit $T_2$ is applied from the shift register 14 or the up/down counter 13 is connected to one input terminal of a NOR gate or circuit 77 and also is connected through an inverter 78 to one input terminal of each of a NOR gate or circuit 79, an AND gate or circuit 80 and a NOR gate or circuit 81.

An input terminal 82, to which the output signal RD of the reference frequency divider 16 (Figure 3) is supplied, is connected to one input terminal of an AND gate or circuit 83, while an input terminal 84 to which the output signal PD of the programmable frequency divider 11 is supplied is connected to one input terminal of an AND gate or circuit 85 and also is connected to one input terminal of an AND gate or circuit 86. An input terminal 87, to which a signal LDT, which is provided by inverting the load signal $\overline{LDT}$ from the timing controller 19 (Figure 3), is supplied, is connected to one input terminal of an AND gate or circuit 88. An input terminal 89, to which the bit A is supplied from the shift register 14 or the latch circuit 15, is connected to another input terminal of the AND gate 88 and to one input terminal of each of AND gates or circuits 90 and 91, and is further connected through an inverter 92 to other input terminals of the AND gates 75, 85 and 86 and to one input terminal of an AND gate or circuit 93. Similarly, an input terminal 94, to which the bit B is supplied from the shift register 14 or the latch circuit 15, is connected to still other input terminals of the AND gate 85 and 88 and other input terminals of the AND gates 80, 93, 91, and is further connected through an inverter 95 to still another input terminal of the AND gate 86. An input terminal 96, to which the most significant bit RMB of the output signal of the reference frequency divider 16 is supplied, is connected to still another input terminal of the AND gate 90. An input terminal 97, to which the most significant bit PMB of the output signal of the programmable frequency divider 11 is supplied, is connected to still another input terminal of the AND gate 93. An input terminal 98 to which the output signal PSO of the pre-scaler (not shown) is supplied is connected to still another input terminal of the AND gate 91.

Output terminals of the AND gates 75 and 72 are connected to other input terminals of the NOR gate 77. Output terminals of the AND gates 83, 85 and 88 are connected to other input terminals of the NOR gate 79. Output terminals of the NOR gates 77 and 79 are connected to respective input terminals of a NOR gate or circuit 99. An output terminal of the NOR gate 99 is connected to a gate terminal of an FET 100 and also connected, through an inverter 101, to the gate terminal of an FET 102. The source terminal of the FET 100 is grounded and the drain terminal thereof is connected to the source terminal of the FET 102, while the drain terminal of the FET 102 is connected to a positive power source terminal $V_{DD}$ and the output terminal 32 is led out from the junction between the drain terminal of the FET 102 and the source terminal of the FET 102.

Output terminals of the AND gates 86, 90, 93 and 91 are connected to respective input terminals of the NOR gate 81, while output terminals of the AND gate 80 and the NOR gate 81 are connected to respective input terminals of a NOR gate or circuit 103. An output terminal of the NOR gate 103 is connected to the gate terminal of an FET 104 and also connected, through an inverter 105, to the gate terminal of an FET 106. The source terminal of the FET 104 is grounded and the drain terminal thereof is connected to the source terminal of the FET 106. The drain terminal of the FET 106 is connected to the positive power source terminal $V_{DD}$ and the output terminal 31 is led out from the junction between the drain terminal of the FET 104 and the source terminal of the FET 106.

When the bit $T_1$ at the input terminal 73 and the bit $T_2$ at the input terminal 76 are both "0", the bit A at the input terminal 89 and the bit B at the input terminal 94 are respectively generated at the output terminals 32 and 31 so that switching of the frequency dividing ratio of the external pre-scaler, the constant of the filter and so on can be carried out in accordance with the combination of these bits.

When the bit $T_1$ is "1" and the bit $T_2$ is "0" the unlocked signal, namely the signal provided by inserting the signal LOCK, appears at the output terminal 32 while the bit B appears at the output terminal 31. When the bits $T_1$ and $T_2$ are both "1" and the bits A and B are both "0", the output signals RD and PD, which are the output signals of the frequency dividers 16 and 11 at the input terminals 82 and 84, appear at the output terminals 32 and 31. In accordance with these output signals, the operation of the phase comparator 18 is checked. When the bits $T_1$ and $T_2$ are both "1" and the bits A and B are respectively "1" and "0", the output signal RD of the reference frequency divider 16 at the input terminal 82 is generated at the output terminal 32 and the most significant bit RMB of thz output signal of the reference frequency divider 16 at the input terminal 96 is generated at the output terminal 31, thereby to check whether or not the data is accurately transmitted from the least significant bit to the most significant bit throughout the inside of the reference frequency divider 16. When the bits $T_1$ and $T_2$ are both "1" and the bits A and B are respectively "0" and "1", the output signal PD of the programmable frequency divider 11 at the input terminal 84 is generated at the output terminal 32 and the most significant bit PMB of the output signal of the programmable frequency divider 11 at the input terminal 97 is generated at the output terminal 31, thereby to check whether the data is accurately transmitted from the least significant bit to the most significant bit throughout the inside of the programmable frequency divider 11. Furthermore, when the bits $T_1$, $T_2$, A and B are all "1", the load signal LDT of the data at the input terminal 87 is generated at the output terminal 32 and used as the timing signal, while the output signal PSO of the pre-scaler at the input terminal 98 is generated at the output terminal 31 and used to check the operation of the pre-scaler.

According to the embodiment of the present invention set forth above: in a first mode, namely the serial data transfer mode (normal mode), the first, second and third signals to be supplied to the timing control means, namely the signals to be supplied to the LAT terminal, DIN terminal and CLK terminal of the timing controller 19, are respectively used as the latch signal for the input data to the memory means (shift register) and the clock signal for the serial data input signal and inputting the serial data; while in a second mode, namely the up/down mode, the above-mentioned first, second and third signals are respectively used as the up/down mode selecting signal and the clock signal for the up/down signal and up/down of the serial data and the up/down counter control signal is processed also by the serial data transfer signal. Thus, although the above-described prior proposal requires three control lines for transferring the serial data and two control lines for controlling the up/down counter, three control lines for transferring the serial data are substantially sufficient in the case of the embodiment of the invention so that the system can be simplified.

In the above-described embodiment, the invention is applied to a PLL circuit for a synthesiser receiver. However, the invention is not limited to the above circuit but can be applied to other circuits.

**Claims**

1. An up/down counting arrangement comprising:

an up/down counter (13);

a data memory means (14);

means for generating a latch signal (LAT), a clock signal (CLK) and data (DIN); and

timing control means (19) responsive to the latch signal (LAT), the clock signal (CLK) and the data (DIN) supplied by the generating means to provide control signals (U/$\overline{D}$, $\overline{LDT}$, $\overline{LTD}$) and clock signals (UDCLK, SFCLK) for controlling the operation of the up/down counter (13) and the data memory means (14), the timing control means (19) being operative to detect the level of the latch signal (LAT) and to provide the control signals (U/$\overline{D}$, $\overline{LDT}$, $\overline{LTD}$) and clock signals (UDCLK, SFCLK) such that, when the latch signal (LAT) is detected to be of a first level, a data latch mode is adopted and the data (DIN) is latched into the data memory means (14) in synchronism with the clock signal (CLK), and, when the latch signal (LAT) is detected to be of a second level, an up/down mode is adopted and the content of the up/down counter (13) is changed in response to the data (DIN) in synchronism with the clock signal (CLK).

2. An arrangement according to claim 1, wherein the timing control means (19) is responsive to a change of the latch signal (LAT) from said first level to said second level to cause the up/down mode to be adopted.

3. An arrangement according to claim 1 or claim 2, wherein the timing control means (19) is response to a change of the latch signal (LAT) from said second level to said first level to cause the data latch mode to be adopted, upon which increasing or decreasing of the count value of the up/down counter (13) is inhibited and said count value is transferred to the data memory means (14).

4. An arrangement according to claim 3, wherein the data memory means (14) is provided with an output terminal (33) for generating the data transferred thereto from the up/down counter (13).

5. An arrangement according to any one of the preceding claims, wherein the up/down counter (13) controls a frequency dividing ratio of a programmable counter in a phase locked loop.

6. An arrangement according to claim 5, wherein the data (DIN) to be transferred to the data memory means (14) contains at least data (Fig. 5) for setting the frequency dividing ratio of a programmable divider (11) in the phase locked loop and data (Fig. 4) for setting the frequency dividing ratio of a reference frequency divider (16), and which is so operative that a final bit (C) of the data (DIN) supplied to the data memory means (14) is checked and when said data is transferred to the programmable divider (11) in the phase locked loop or the reference frequency divider (16).

7. An arrangement according to any one of the preceding claims, wherein the data memory means (14) comprises a shift register.

**Patentansprüche**

1. Anordnung zum Vorwärts/Rückwärtszählen mit einem Vorwärts/Rückwärts-Zähler (13), mit einer Datenspeichereinrichtung (14), mit einer Generatoreinrichtung zur Erzeugung eines Verriegelungssignals (LAT), eines Taktsignals (CLK) und von Daten (DIN), sowie mit einer auf die von von der Generatoreinrichtung abgegebenen Signale, d.h. das Verriegelungssignal (LAT), das Taktsignal (CLK) und die Daten (DIN) ansprechenden Zeitsteuereinrichtung (19) zur Erzeugung von Steuersignalen (U/D̄, LDT, LTD) und Taktsignalen (UDCLK, SFCLK) für die Funktionssteuerung des Vorwärts/Rückwärts-Zählers (13) und der Datenspeichereinrichtung (14), wobei diese Zeitsteuereinrichtung (19) den Pegel des Verriegelungssignals (LAT) feststellt und die Steuersignale (U/D̄, LDT, LTD) und die Taktsignale (UDCLK, SFCLK) in der Weise erzeugt, daß

—dann, wenn festgestellet wird, daß das Verriegelungssignal (LAT) einen ersten Pegel hat, ein Datenverriegelungsmodus eingerichtet wird und die Daten (DIN) synchron mit dem Taktsignal (CLK) in der Datenspeichereinrichtung (14) verreigelt werden, und

—dann, wenn festgestellt wird, daß das Verriegelungssignal (LAT) einen zweiten Pegel hat, ein ein Vorwärts/Rückwärts-Zählmodus eingerichtet wird und der Inhalt des Vorwärts/Rückwärts-Zählers (13) in Abhängigkeit von den Daten (DIN) synchron mit dem Taktsignal (CLK) geänderrt wird.

2. Anordnung nach Anspruch 1, bei der die Zeitsteuereinrichtung (19) bei einem Wechsel des Verriegelungssignals (LAT) von dem ersten Pegel auf den zweiten Pegel anspricht und veranlaßt, daß der Vorwärts/Rückwärts-Zählmodus eingestellt wird.

3. Anordnung nach Anspruch 1 oder 2, bei der die Zeitsteuereinrichtung (19) bei einem Wechsel des Verriegelungssignals (LAT) von dem zweiten Pegel auf den ersten Pegel anspricht und veranlaßt, daß der Datenverriegelungsmodus eingestellt wird, voraufhin ein Anwachsen oder Abnehmen des Zählstandes in dem Vorwärts/Rückwärts-Zählers (13) verhindert und der vorhandene Zählstand zu der Datenspeichereinrichtung (14) übertragen wird.

4. Anordnung nach Anspruch 3, bei der die Datenspeichereinrichtung (14) einen Ausgang (33) zur Liegerung der ihm vom dem Vorwärts/Rückwärts-Zähler (13) zugeführten Daten aufweist.

5. Anordnung nach einem der vorhergehenden Ansprüche, bei der der Vorwärts/Rückwärts-Zähler (13) das Frequenzteilerverhältnis eines programmierbaren Zähler in einer Phasenregelschleife steuert.

6. Anordnung nach Anspruch 5, bei der die zu der Datenspeichereinrichtung (14) zu übertragenden Daten (DIN) zumindest Daten (Fig. 5) zur Einstellung des Frequenzteilerverhältnisses eines programmierbaren Zählers (11) in der Phasenregelschleife sowie Daten (Fig. 4) zur Einstellugn eines Referenz-Frequenzteilers (16) enthalten, und bei der ein letztes Bit (C) der der Datenspeichereinrichtung (14) zugeführreten Daten (DIN) geprüft wird und die genannten Daten dann zu dem programmierbaren Teiler (11) in der Phasenregelschleife oder zu dem Referenz-Frequenzteiler (16) übertragen werden.

7. Anordnung nach einem der vorhergehenden Ansprüche, bei der die Datenspeichereinrichtung (14) ein Schieberegister aufweist.

**Revendications**

1. Dispositif de comptage progressif/régressif comprenant:
    un compteur progressif/régresif (13);
    un moyen à mémoire de données (14);
    un moyen pour engendrer un signal de verrouillage (LAT), un signal d'horloge (CLK) et des

données (DIN); et

un moyen de commande de synchronisation (19) réagissant au signal de verrouillage (LAT), au signal d'horloge (CLK) at aux donées (DIN) fournis pour le moyen générateur pour fournir des signaux de commande (U/$\overline{D}$, $\overline{LDT}$,$\overline{LTD}$) et des signaux d'horloge (UDCLK, SFCLK) pour commander le fonctionnement du compteur progressif/régressif (13) et du moyen à mémoire de données (14), le moyen de commande de synchronisation (19) étant actif pour détecter le niveau du signal de verrouillage ($\overline{LAT}$) et pour fournir les signaux de commande (U/$\overline{D}$,$\overline{LDT}$, $\overline{LTD}$) et les signaux d'horloge (UDCLK, SFCLK) de telle sorte que, lorsque le signal de verrouillage (LAT) est détecté comme ayant un premier niveau, un mode de verrouillage de données est adopté et les données (DIN) sont verrouillées dans le moyen à mémoire de données (14) en synchronisme avec le signal d'horloge (CLK), et, quand le signal de verrouillage (LAT) est détecté comme ayant un deuxième niveau, un mode progressif/régressif est adopté et le contenu du compteur progressif/régressif (13) est changé en réponse aux données (DIN) en synchronisme avec le signal d'horloge (CLK).

2. Dispositif selon la revendication 1, dans lequel le moyen de commande de synchronisation (19) réagit à un passage du signal de verrouillage (LAT) du premier niveau au deuxième niveau pour faire en sortie que soit adopté le mode progressif/régressif.

3. Dispositif selon l'une quelconque des revendications 1 et 2, dans lequel le moyen de commande de synchronisation (19) réagit à un passage du signal de verrouillage (LAT) du deuxième niveau au premier niveau pour faire en sorte que soit adopté le mode de verrouillage de données, dans lequel est interdite l'augmentation ou la diminution de la valeur de compte du compteur progressif/régressif (13) et la valeur de compte est transférée jusqu'au moyen à mémoire de données (14).

4. Dispositif selon la revendication 3, dans lequel le moyen à mémoire de données (14) est pourvu d'une borne de sortie (33) pour engendrer les données qui lui sont transférées à partir du compteur progressif/régressif (13).

5. Dispositif selon l'une quelconque des revendications 1 à 4, dans lequel le compteur progressif/régressif (13) contrôle le rapport de division de fréquence d'un compteur programmable dans une oucle à blocage de phase.

6. Dispositif selon la revendication 5, dans lequel les données (DIN) à transférer jusqu'au moyen à mémoire de données (14) contiennent au moins des données (Figure 5) pour régler le rapport de division de fréquence d'un diviseur programmable (11) dans la boucle à blocage de phase et des données (Figure 4) pour régler le rapport de division de fréquence d'un diviseur de fréquence de référence (16), et qui agissent de telle sorte qu'un dernier bit (C) des données (DIN) est contrôlé et les données sont ensuite transférées jusqu'au diviseur programmable (11) dans la boucle à blocage de phase ou jusqu'au diviseur de fréquence de référence (16).

7. Dispositif selon l'une quelconque des revendications 1 à 6, dans lequel le moyen à mémoire de données (14) comprend un registre à décalage.

# F I G. 1

# F I G. 2A

# F I G. 2B

# F I G. 2C

# F I G. 2D

# F I G. 2E

# FIG. 3

PROGRAMMABLE DIVIDER — 11

10

MPX — 12

33

U/D̄ COUNTER — 13

19

CLK
TIMING
LAT
CONT
DIN

20

21

22

U/D̄
UDCLK
L̄D̄T̄
L̄T̄D̄
SFCLK

SHIFT REGISTER — 14

LATCH CIRCUIT — 15

PI₁  PI₂

REFERENCE DIVIDER — 16

17

OSC

23

1/N

24

18

PC

25

26

27

28

29

31

a

30

32

b

EP 0 105 378 B1

2

EP 0 105 378 B1

FIG. 4

20 BITS

| $R_0$ | $R_1$ | $R_2$ | $R_3$ | $R_4$ | $R_5$ | $R_6$ | $R_7$ | $R_8$ | $R_9$ | $R_{10}$ | $R_{11}$ | $R_{12}$ | $R_{13}$ | $PI_1$ | $PI_2$ | A | B | $T_1$ | C |

FIG. 5

20 BITS

| $N_0$ | $N_1$ | $N_2$ | $N_3$ | $N_4$ | $N_5$ | $N_6$ | $N_7$ | $N_8$ | $N_9$ | $N_{10}$ | $N_{11}$ | $N_{12}$ | $N_{13}$ | $N_{14}$ | $N_{15}$ | $N_{16}$ | $N_{17}$ | $T_2$ | C |

FIG. 6A

FIG. 6B    $N_0$    $N_1$    $N_2$    $N_3$    $T_2$    C

FIG. 6C

FIG. 7A

FIG. 7B

FIG. 7C

*F I G. 8*

EP 0 105 378 B1

## F I G. 9

## F I G. 12

| INPUT | | | | OUTPUT | | MODE |
|---|---|---|---|---|---|---|
| T₁ | T₂ | A | B | AO | BO | |
| 0 | 0 | | | A | B | NORMAL |
| 1 | 0 | | | UNLOCK | B | UNLOCK |
| 1 | 1 | 0 | 0 | RD | PD | PC TEST |
| 1 | 1 | 1 | 0 | RD | RMB | RD TEST |
| 1 | 1 | 0 | 1 | PD | PMB | PD TEST |
| 1 | 1 | 1 | 1 | LDT | PSO | PS TEST AND TIMING |

5

FIG. 10A LAT
FIG. 10B DIN
FIG. 10C CLK
FIG. 10D S₁
FIG. 10E S₂
FIG. 10F S₃
FIG. 10G S₄
FIG. 10H S₅
FIG. 10I S₆
FIG. 10J $\overline{LDT}$
FIG. 10K $\overline{LTD}$
FIG. 10L U/$\overline{D}$
FIG. 10M SFCLK
FIG. 10N UDCLK

FIG. 11

FIG. 13